# EUROPEAN PATENT APPLICATION

(11) **EP 4 564 595 A1**
(43) Date of publication of application: **04.06.2025**
(21) Application number: 23846932.4
(22) Date of filing: 24.07.2023
(51) Int. Cl.: H01Q 1/02, H05K 7/20

(54) **HEAT SINK STRUCTURE**

(30) Priority: 29.07.2022 KR 20220094978; 21.07.2023 KR 20230095149
(71) Applicant: KMW Inc., Hwaseong-si, Gyeonggi-do 18462 (KR)
(72) Inventor: KIM, Duk Yong, Yongin-si Gyeonggi-do 17086 (KR); LEE, Kang Hyun, Hwaseong-si Gyeonggi-do 18442 (KR); JI, Kyo Sung, Hwaseong-si Gyeonggi-do 18484 (KR); RYU, Chi Back, Hwaseong-si Gyeonggi-do 18392 (KR); HAN, Kyu Tae, Incheon 21387 (KR); YANG, Jun Woo, Hwaseong-si Gyeonggi-do 18611 (KR)
(74) Representative: Impuls legal PartG mbB
(86) International application number: PCT/KR2023/010627
(87) International publication number: WO 2024/025273

(57) **Abstract**

A heat sink structure according to the present invention comprises: a cover plate having one surface on which a printed circuit board provided with a heat generating element is mounted to receive heat from the heat generating element; and a heat sink body part having an inner space divided, by the cover plate, into a receiving space, in which the printed circuit board is received, and a refrigerant chamber in which a refrigerant is filled, wherein a plurality of refrigerant condensation grooves, in which a gaseous refrigerant thermally exchanged with the cover plate is condensed while flowing, are formed on at least one surface of the refrigerant chamber so that a gaseous refrigerant thermally exchanged with heat generated by the heat generating element is rapidly condensed and thus the heat generated in the heat generating element can be rapidly dissipated.

## Description

### [Technical Field]

The present disclosure relates to a heat sink structure, and more particularly, to a heat sink structure for discharging heat generated from a heat source, such as an antenna element mounted on a printed circuit board.

### [Background Art]

A wireless communication technique, for example, a multiple input multiple output (MIMO) technique is a technique that significantly increases a data transmission capacity by using multiple antennas, and is a spatial multiplexing scheme in which a transmitter transmits different data through respective transmission antennas and a receiver distinguishes between transmission data through proper signal processing.

Accordingly, as the numbers of transmission and reception antennas are simultaneously increased, more data can be transmitted because a channel capacity is increased. For example, if the number of antennas is increased to 10, a channel capacity that is about 10 times compared to a current single antenna system is secured by using the same frequency band.

In 4G LTE-advanced, up to 8 antennas are used. In the 5G stage, base station equipment having 64 or 128 or more antennas is used, which is called a massive MIMO technique. A current cell operation is a 2 dimension, whereas the massive MIMO technique enables 3-D beamforming, which is also called full dimension (FD)-MIMO.

In the massive MIMO technique, as the number of antennas (ANTs) is increased, the numbers of corresponding transmitters and filters are also increased. Nevertheless, RF parts (e.g., an antenna, a filter, a power amplifier, and a transceiver) are practically made small, light, and cheap due to lease costs for an installation place or spatial restriction. Massive MIMO requires a high output for coverage expansion, but consumption power and the amount of heat generated attributable to such a high output acts as negative factors in reducing weight and a size.

In particular, when MIMO antennas in which modules having RF elements and digital elements implemented therein have been coupled in a stack structure are installed in a limited space, there emerges a need for compactness and a miniaturization design for a plurality of layers that constitute the MIMO antennas in order to maximize installation simplicity or space utilization. In this case, there is a need for a design relating to a new heat dissipation structure for heat that is generated from communication parts mounted on the plurality of layers.

Korean Patent Application Publication No. 10-2019-0118979 (published on October 21, 2019) (hereinafter referred to as a "conventional technology") discloses a "multi input and multi output antenna apparatus" to which a heat dissipation structure for the compactness and miniaturization design of a plurality of layers that constitute MIMO antennas has been applied.

The conventional technology includes a heat dissipation body in which a heat dissipation fin is provided to protrude therefrom and multiple unit heat dissipation bodies installed in the heat dissipation body. The multiple unit heat dissipation bodies have one end brought into contact with the heat dissipation element of an antenna substrate, and have multiple sub-heat dissipation fins that discharge heat conducting from the heat dissipation element to the outside provided on the other end thereof.

However, the conventional technology has problems in that rapid heat dissipation is difficult because a structure for discharging the heat of the heat dissipation element consists of only a mechanical structure, that is, an air cooling type heat dissipation structure through the exchange of heat with external air and a size is increased because a more mechanical heat dissipation structure is required for the rapid heat dissipation.

### [DISCLOSURE]

### [Technical Problem]

A technical object of the present disclosure is to provide a heat sink structure which can rapidly discharge heat generated from a heat dissipation element by rapidly condensing a gaseous refrigerant subjected to a heat exchange with the heat generated from the heat dissipation element, can minimize a size, and can also improve heat dissipation performance.

Technical objects of the present disclosure are not limited to the aforementioned objects, and the other objects not described above may be evidently understood from the following description by those skilled in the art.

### [Technical Solution]

In order to achieve the object, a heat sink structure according to the present disclosure includes a cover plate and a heat sink body part. A printed circuit board including a heat dissipation element is mounted on one surface of the cover plate. The cover plate receives the heat of the heat dissipation element. An internal space of the heat sink body part is partitioned into an accommodation space and a refrigerant chamber by the cover plate. The printed circuit board is accommodated in the accommodation space. The refrigerant chamber is filled with the refrigerant. A plurality of refrigerant condensing grooves is formed in at least one surface of the refrigerant chamber. A gaseous refrigerant subjected to a heat exchange with the cover plate is condensed in the plurality of refrigerant condensing grooves while flowing.

The plurality of refrigerant condensing grooves may be formed on a surface that belongs to the refrigerant chamber and that faces the other surface of the cover plate.

The cover plate may include a first cover part and a second cover part. The first cover part may be a part corresponding to the heat dissipation element. The second cover part may be formed to extend from one side of the first cover part. The plurality of refrigerant condensing grooves may be formed at parts corresponding to the second cover part.

A plurality of heat exchange grooves subjected to a heat exchange with the refrigerant may be formed in a surface that belongs to the first cover part and that faces the refrigerant chamber.

The width of the refrigerant chamber may be formed to be smaller than the width of the accommodation space. The cover plate may cover one opened surface that belongs to the refrigerant chamber and that communicates with the accommodation space.

A surface that belongs to the refrigerant chamber and that faces the other surface of the cover plate may include a first opposite surface and a second opposite surface. The first opposite surface may face the first cover part. The second opposite surface may face the second cover part. A plurality of refrigerant condensing grooves may be formed in the second opposite surface. A side of each of the plurality of refrigerant condensing grooves, which is directed toward the first opposite surface, may be formed of a slant part.

The slant part may be formed of a plurality of first step parts.

A second step part may be formed at the edge of the refrigerant chamber. The edge of the cover plate may be seated in the second step part. The other surface of the cover plate may be disposed by being spaced apart from a surface that belongs to the refrigerant chamber and that faces the other surface of the cover plate.

A third step part may be formed at the edge of the cover plate. The third step part may be seated in the second step part.

A plurality of support protrusions may be formed in the other surface of the cover plate. The plurality of support protrusions may separate the other surface of the cover plate from a surface that belongs to the refrigerant chamber and that faces the other surface of the cover plate, and may support the other surface of the cover plate.

A plurality of support grooves may be formed in the surface that belongs to the refrigerant chamber and that faces the other surface of the cover plate. The plurality of support protrusions may be inserted into the plurality of support grooves, respectively.

A plurality of mounting grooves may be formed on one surface of the cover plate. The printed circuit board may be mounted on the plurality of mounting grooves. The plurality of mounting grooves may extend into the plurality of support protrusions, respectively.

A plurality of welding grooves may be formed at parts that belong to the outer surface of the heat sink body part and that correspond to the plurality of support protrusions portions. The plurality of welding grooves may be for laser-welding each of the plurality of support protrusions onto the heat sink body part.

A plurality of welding point protrusions may further be formed in the outer surface of the heat sink body part. The plurality of welding grooves may be formed in the plurality of welding point protrusions, respectively.

A plurality of welding coupling parts may be formed in the outer surface of the heat sink body part in a way to protrude therefrom. The ends of the plurality of heat dissipation fins may be coupled to the plurality of welding coupling parts, respectively, by laser welding. The plurality of welding coupling parts may be formed lengthwise in the width direction of the refrigerant chamber. The plurality of welding point protrusions may extend from one side of the plurality of welding coupling parts.

The details of other embodiments are included in the detailed description and drawings.

### [Advantageous Effects]

The heat sink structure according to the present disclosure has effects in that heat generated from the heat dissipation element can be rapidly discharged by rapidly condensing a gaseous refrigerant because the plurality of refrigerant condensing grooves in which the gaseous refrigerant subjected to a heat exchange with the cover plate is condensed therethrough is formed in at least one surface of the refrigerant chamber and heat dissipation performance is improved while minimizing a size.

Effects of the present disclosure are not limited to the aforementioned effects, and the other effects not described above may be evidently understood by those skilled in the art from the claims.

### [Description of Drawings]

FIG. 1 is a perspective view illustrating a heat sink structure according to an embodiment of the present disclosure.
FIG. 2 is an exploded perspective view of FIG. 1.
FIG. 3 is a bottom perspective view and partial enlarged view illustrating a cover plate illustrated in FIG. 2.
FIG. 4 is an incisional perspective view and partial enlarged view illustrating the cover plate illustrated in FIG. 2.
FIG. 5 is an incisional perspective view and partial enlarged view illustrating a heat sink body part illustrated in FIG. 2.
FIG. 6 is a bottom perspective view and partial enlarged view illustrating a heat sink body part illustrated in FIG. 2.
FIG. 7 is a lateral cross-sectional view of a coupling state of a heat sink structure according to an embodiment of the present disclosure.

### [Description of Reference Numerals]

100: cover plate 106: third step part
110: first cover part 120: cover part
131, 132: support protrusion 141, 142: mounting groove
150: heat exchange groove 200: heat sink body part
210: accommodation space 220: refrigerant chamber
221: first opposite surface 222: second opposite surface
226: second step part 231, 232: support groove
250: refrigerant condensing groove 255: slant part
255A: first step part 271, 272: welding point protrusion
281, 282: welding groove

### [Best Mode]

Hereinafter, a heat sink structure according to an embodiment of the present disclosure is described with reference to the drawings.

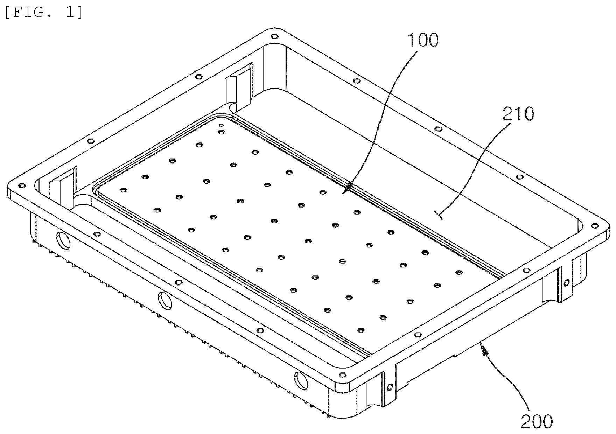

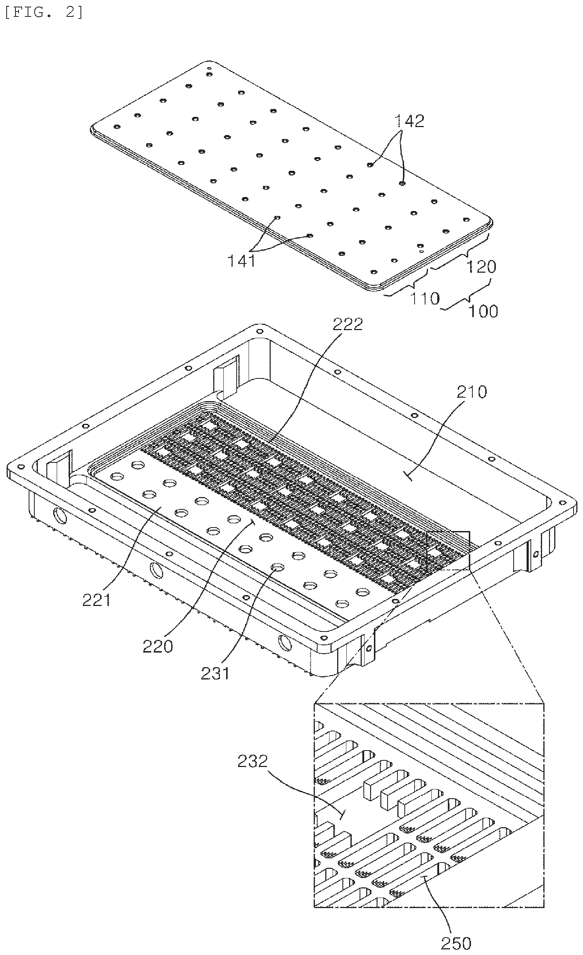

FIG. 1 is a perspective view illustrating a heat sink structure according to an embodiment of the present disclosure. FIG. 2 is an exploded perspective view of FIG. 1.

In the following description, one surface may be an upper surface in drawings illustrated in FIGS. 1 and 2, and the other surface may be a lower surface in the drawings illustrated in FIGS. 1 and 2.

Referring to FIGS. 1 and 2, the heat sink structure according to an embodiment of the present disclosure may include a cover plate 100 and a heat sink body part 200.

A printed circuit board (not illustrated) equipped with a heat dissipation element may be mounted on one surface of the cover plate 100.

The heat dissipation element may be an element that is mounted on the printed circuit board and that generates heat. The heat dissipation element may include an electronic part that generates predetermined heat as the electronic part is driven when power is supplied thereto. For example, the heat dissipation element may be an Rx element and a Tx element that are responsible for the output and transmission of a signal in an antenna apparatus.

Heat generated from the heat dissipation element may be transferred to the cover plate 100 because the printed circuit board is mounted on one surface of the cover plate 100. The cover plate 100 may receive the heat of the heat dissipation element.

The cover plate 100 may be manufactured by using an aluminum material or an aluminum alloy material. In addition, the cover plate may be variously manufactured by using a known metal material having excellent heat dissipation performance.

The heat sink body part 200 may have an internal space. The heat sink body part 200 may be a partial construction of a housing having a sealed internal space. The internal space of the heat sink body part 200 may have one surface opened. The heat sink body part 200 is formed in an approximately hexahedron shape, and may have one surface opened. The internal space of the heat sink body part 200 is formed in a hexahedron shape, and may have one surface opened.

The internal space of the heat sink body part 200 may be partitioned into an accommodation space 210 and a refrigerant chamber 220 by the cover plate 100. That is, the cover plate 100 is disposed within the heat sink body part 200, and may partition the internal space of the heat sink body part 200 into the accommodation space 210 and the refrigerant chamber 220. In this case, the accommodation space 210 may be a space in which the printed circuit board is accommodated. The refrigerant chamber 220 may be a space in which a refrigerant is filled.

When the cover plate 100 is in the state in which the cover plate has partitioned the internal space of the heat sink body part 200 into the accommodation space 210 and the refrigerant chamber 220, the accommodation space 210 may be a space that is disposed on one surface side of the cover plate 100, and the refrigerant chamber 220 may be a space that is disposed on the other surface side of the cover plate 100.

The refrigerant chamber 220 may be formed on a bottom surface of the accommodation space 210. However, the refrigerant chamber 220 does not need to be essentially formed on the bottom surface of the accommodation space 210, and may be formed on at least one of the bottom surface and four sides of the accommodation space 210. The refrigerant chamber 220 may be formed in a plural number. In this case, the cover plate 100 may be provided as a plurality of cover plates 100. The plurality of cover plates 100 may each partition each of the plurality of refrigerant chambers 220 from the accommodation space 210.

The width of the refrigerant chamber 220 may be formed to be smaller than the width of the accommodation space 210. The cover plate 100 may cover one opened surface that belongs to the refrigerant chamber 220 and that communicates with the accommodation space 210. The cover plate 100 may partition the internal space of the heat sink body part 200 into the accommodation space 210 and the refrigerant chamber 220 by covering the one opened surface of the refrigerant chamber 220.

However, the width of the refrigerant chamber 220 does not need to be essentially formed to be smaller than the width of the accommodation space 210, and may be formed to be identical with or greater than the width of the accommodation space 210. Even in this case, the cover plate 100 may partition the internal space of the heat sink body part 200 into the accommodation space 210 and the refrigerant chamber 220.

The cover plate 100 may include a first cover part 110 and a second cover part 120.

The width of the first cover part 110 may be formed to be narrower than the width of the second cover part 120. The width of the second cover part 120 may be formed to be wider than the width of the first cover part 110. The length of the first cover part 110 may be formed to be identical with the length of the second cover part 120.

The first cover part 110 may be a part corresponding to the heat dissipation element. That is, a part that belongs to the printed circuit board and on which the heat dissipation element is mounted is mounted on one surface of the first cover part 110, and thus the first cover part 110 may receive the heat of the heat dissipation element. The printed circuit board may be formed in the same size as one surface of the cover plate 100 or may be formed in a size greater than one surface of the cover plate 100, and may be mounted on the entire one surface of the cover plate 100. In this case, the heat dissipation element may be mounted on a part that belongs to the printed circuit board and that is mounted on the first cover part 110, and may not be mounted on a part that belongs to the printed circuit board and that is mounted on the second cover part 120. Alternatively, the printed circuit board may be formed in a size smaller than one surface of the cover plate 100 and mounted on one surface of the first cover part 110, and may not be mounted on one surface of the second cover part 120.

The second cover part 120 may be formed by extending from one side of the first cover part 110. The first cover part 110 may be formed in the form of a plate that forms one side part of the cover plate 100. The second cover part 120 may be formed in the form of a plate that forms the other side part, that is, the remaining part of the cover plate 100.

The heat sink body part 200 may be manufactured by using an aluminum material or an aluminum alloy material. In addition, the heat sink body part may be variously manufactured by using a known metal material having excellent heat dissipation performance.

A bottom surface of the refrigerant chamber 220 may include a first opposite surface 221 and a second opposite surface 222. The bottom surface of the refrigerant chamber 220 may be a surface that faces the other surface of the cover plate 100. In this case, the first opposite surface 221 may face the first cover part 110 of the cover plate 100, and the second opposite surface 222 may face the second cover part 120 of the cover plate 100.

The width of the first opposite surface 221 may be formed to be narrower than the width of the second opposite surface 222. The width of the second opposite surface 222 may be formed to be wider than the width of the first opposite surface 221. The length of the first opposite surface 221 may be formed to be identical with the length of the second opposite surface 222.

The width of the first opposite surface 221 may be formed to be identical with the width of the first cover part 110. The length of the first opposite surface 221 may be formed to be identical with the length of the first cover part 110. The width of the second opposite surface 222 may be formed to be identical with the width of the second cover part 120. The length of the second opposite surface 222 may be formed to be identical with the length of the second cover part 120.

A plurality of refrigerant condensing grooves 250 may be formed in the second opposite surface 222 of the refrigerant chamber 220. However, the plurality of refrigerant condensing grooves 250 does not need to be essentially formed in the second opposite surface 222 of the refrigerant chamber 220, and may be formed in at least one of the bottom surface and four sides of the refrigerant chamber 220. That is, the plurality of refrigerant condensing grooves 250 may be formed in at least one surface of the refrigerant chamber 220.

The plurality of refrigerant condensing grooves 250 may be formed in a surface that belongs to the refrigerant chamber 220 and that faces the other surface of the cover plate 100.

The plurality of refrigerant condensing grooves 250 may be formed in a part corresponding to the second cover part 120 of the cover plate 100.

In the plurality of refrigerant condensing grooves 250, a gaseous refrigerant subjected to a heat exchange with the cover plate 100 may be condensed while flowing. However, in the present embodiment, the plurality of refrigerant condensing grooves 250 is formed in the second opposite surface 222. Accordingly, in the plurality of refrigerant condensing grooves 250, after the gaseous refrigerant subjected to a heat exchange with the first cover part 110 in the first opposite surface 221, the gaseous refrigerant that flows into the second opposite surface 222 may be condensed while flowing.

The plurality of refrigerant condensing grooves 250 may be formed lengthwise in the width direction of the cover plate 100. The plurality of refrigerant condensing grooves 250 may be formed lengthwise in a direction in which the first cover part 110 and the second cover part 120 are disposed. The plurality of refrigerant condensing grooves 250 may be formed lengthwise in the width direction of the refrigerant chamber 220. The plurality of refrigerant condensing grooves 250 may be formed lengthwise in a direction in which the first opposite surface 221 and the second opposite surface 222 are disposed.

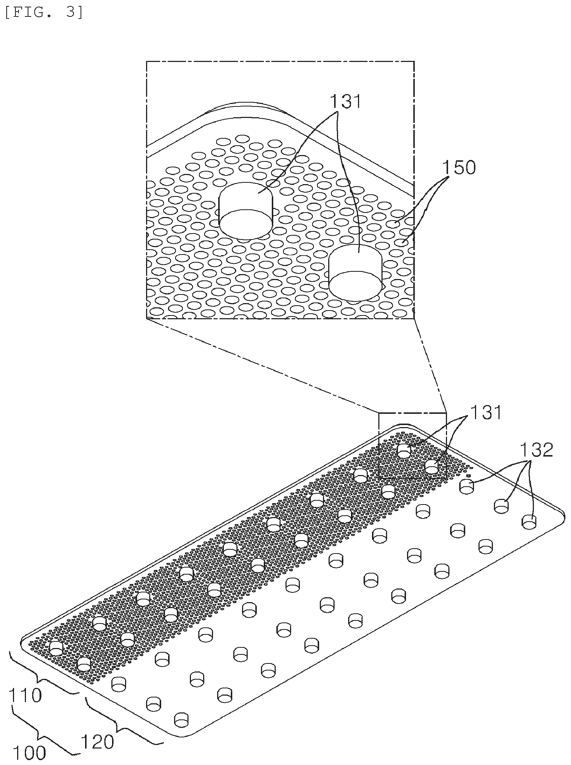

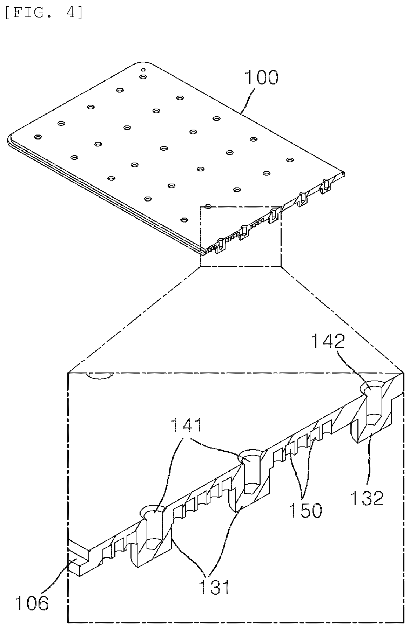

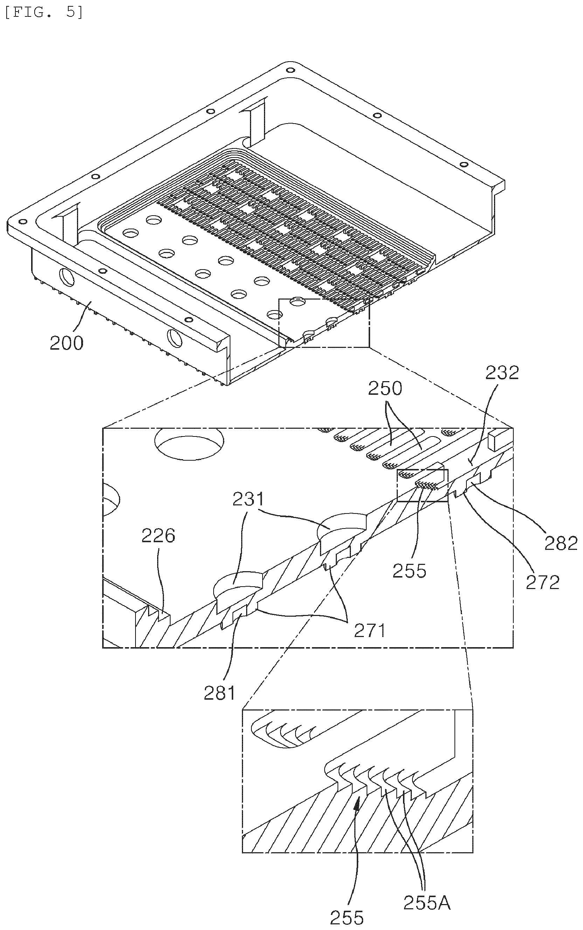

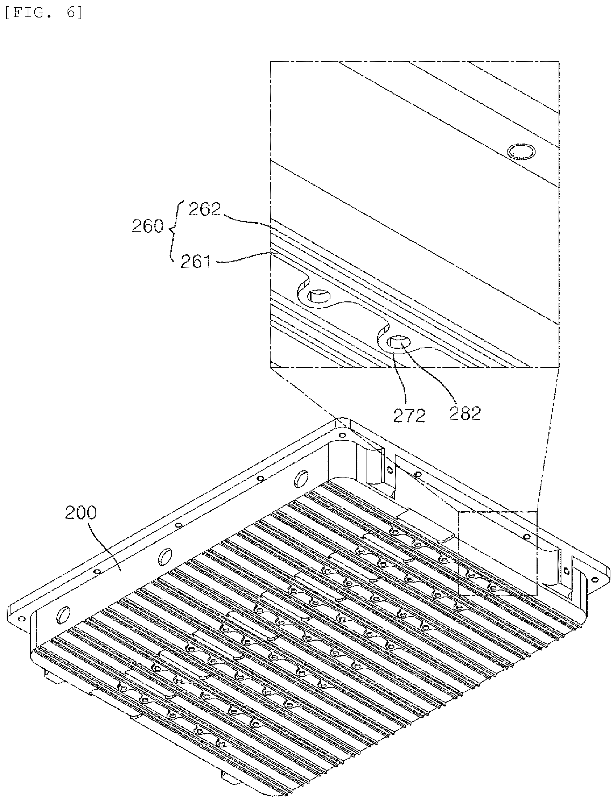

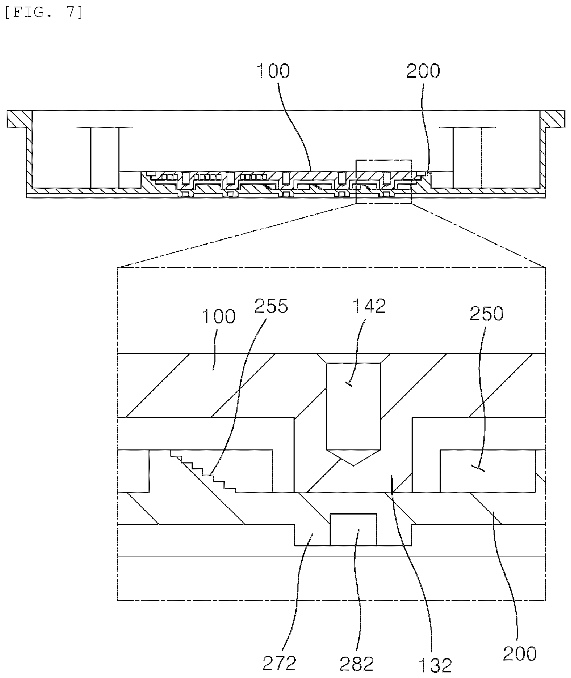

FIG. 3 is a bottom perspective view and partial enlarged view illustrating the cover plate illustrated in FIG. 2. FIG. 4 is an incisional perspective view and partial enlarged view illustrating the cover plate illustrated in FIG. 2. FIG. 5 is an incisional perspective view and partial enlarged view illustrating the heat sink body part illustrated in FIG. 2. FIG. 6 is a bottom perspective view and partial enlarged view illustrating the heat sink body part illustrated in FIG. 2. FIG. 7 is a lateral cross-sectional view of a coupling state of the heat sink structure according to an embodiment of the present disclosure.

Referring to FIGS. 2 to 7, a plurality of heat exchange grooves 150 subjected to a heat exchange with the refrigerant may be formed in the other surface of the first cover part 110. In this case, the other surface of the first cover part 110 may be a surface that faces the refrigerant chamber 220. That is, the plurality of heat exchange grooves 150 subjected to a heat exchange with the refrigerant may be formed in a surface that belongs to the first cover part 110 and that faces the refrigerant chamber 220.

The plurality of heat exchange grooves 150 may each be formed in a circle. However, the plurality of heat exchange grooves 150 may each be formed in a polygon, such as a triangle or a quadrangle.

The thickness of the cover plate 100 is inevitably formed to be thick because a form of a portion of the cover plate 100 in which a part mounted on the printed circuit board is seated needs to be changed depending on a form of the part. If the thickness of the cover plate 100 is formed to be thick as described above, the heat of the heat dissipation element mounted on the printed circuit board may not be rapidly transferred to the refrigerant chamber 220 through the cover plate 100 due to the thick thickness of the cover plate 100. Although the thickness of the cover plate 100 is formed to be thick, a contact area with the refrigerant disposed in the first opposite surface 221 may be widened because the plurality of heat exchange grooves 150 is formed in the first cover part 110. Accordingly, the heat of the heat dissipation element mounted on the printed circuit board can be rapidly transferred to the refrigerant of the refrigerant chamber 220 through the first cover part 110, and may be subjected to a heat exchange with the refrigerant.

A side of each of the plurality of refrigerant condensing grooves 250, which is directed toward the first opposite surface 221, may be formed of a slant part 255. The refrigerant subjected to a heat exchange with the heat of the heat dissipation element through the first cover part 110 in the first opposite surface 221 can be easily moved to the plurality of refrigerant condensing grooves 250 through the slant parts 255 that are formed in the plurality of refrigerant condensing grooves 250, respectively.

The slant part 255 may be formed of a plurality of first step parts 255A. The refrigerant can be rapidly condensed because the plurality of first step parts 255A widens a contact area with the refrigerant disposed in the plurality of refrigerant condensing grooves 250.

A second step part 226 may be formed at the edge of the refrigerant chamber 220. The edge of the cover plate 100 is seated in the second step part 226, and thus the other surface of the cover plate 100 may be disposed by being spaced apart from a surface that belongs to the refrigerant chamber 220 and that faces the other surface of the cover plate 100. That is, a surface that belongs to the cover plate 100 and that is directed toward the bottom surface of the refrigerant chamber 220 may be disposed by being spaced apart from the bottom surface of the refrigerant chamber 220. The second step parts 226 widen a contact area with the edge of the cover plate 100, and thus the heat of the heat dissipation element can be transferred to the second step part 226 through the edge of the cover plate 100 as much as possible.

A third step part 106 seated in the second step part 226 of the refrigerant chamber 220 may be formed at the edge of the cover plate 100. The third step part 106 widens a contact area with the second step part 226, and thus the heat of the heat dissipation element can be transferred to the second step part 226 through the third step part 106 of the cover plate 100 as much as possible.

A plurality of support protrusions 131 and 132 may be formed in the other surface of the cover plate 100. The plurality of support protrusions 131 and 132 may separate the other surface of the cover plate from a surface that belongs to the refrigerant chamber 220 and that faces the other surface of the cover plate 100, and may support the other surface of the cover plate 100. The plurality of support protrusions 131 and 132 is formed in a surface that belongs to the cover plate 100 and that is directed toward the bottom surface of the refrigerant chamber 220, may separate the surface from the bottom surface of the refrigerant chamber 220, and may support the surface that belongs to the cover plate 100 and that is directed toward the bottom surface of the refrigerant chamber 220.

The plurality of support protrusions 131 and 132 may include a plurality of first support protrusions 131 formed in the other surface of the first cover part 110 and a plurality of second support protrusions 132 formed in the other surface of the second cover part 120.

The plurality of first support protrusions 131 may be formed in a surface that belongs to the first cover part 110 and that is directed toward the first opposite surface 221. The plurality of second support protrusions 132 may be formed in a surface that belongs to the second cover part 120 and that is directed toward the second opposite surface 222.

The plurality of first support protrusions 131 may be disposed in two columns in the width direction of the first cover part 110. The plurality of second support protrusions 132 may be disposed in three columns in the width direction of the second cover part 120.

The plurality of first support protrusions 131 and the plurality of second support protrusions 132 may be formed in the same shape. However, each of the plurality of first support protrusions 131 and each of the plurality of second support protrusions 132 may each be formed in different shapes. In the present embodiment, each of the plurality of first support protrusions 131 and each of the plurality of second support protrusions 132 may each be formed to have a circle, that is, the same shape, but, may be formed in a polygon, such as a triangle or a quadrangle.

Furthermore, a plurality of support grooves 231 and 232 into which the plurality of support protrusions 131 and 132 is inserted, respectively, may be formed in a surface that belongs to the refrigerant chamber 220 and that faces the other surface of the cover plate 100. The plurality of support grooves 231 and 232 is formed in the bottom surface of the refrigerant chamber 220, and thus the ends of the plurality of support protrusions 131 and 132 may be inserted into the plurality of support grooves, respectively.

The plurality of support grooves 231 and 232 may include a plurality of first support grooves 231 formed in the first opposite surface 221 and a plurality of second support grooves 232 formed in the second opposite surface 222.

The ends of the plurality of first support protrusions 131 may be inserted into the plurality of first support grooves 231, respectively. The plurality of second support protrusions 132 may be inserted into the ends of the plurality of second support grooves 232, respectively.

The plurality of first support grooves 231 may be formed in a surface that belongs to the refrigerant chamber 220 and that is directed toward the other surface of the first cover part 110. The plurality of second support grooves 232 may be formed in a surface that belongs to the refrigerant chamber 220 and that is directed toward the other surface of the second cover part 120.

The plurality of first support grooves 231 may be formed at locations corresponding to the plurality of first support protrusions 131, respectively. The plurality of second support grooves 232 may be formed at locations corresponding to the plurality of second support protrusions 132, respectively. That is, the plurality of first support grooves 231 may be disposed in two columns in the width direction of the first opposite surface 221. The plurality of second support grooves 232 may be disposed in three columns in the width direction of the second opposite surface 222.

The plurality of first support grooves 231 and the plurality of second support grooves 232 may be formed in different shapes. However, the plurality of first support grooves 231 and the plurality of second support grooves 232 may be formed in the same shape. In the present embodiment, the plurality of first support grooves 231 and the plurality of second support grooves 232 are formed in different shapes. Accordingly, the plurality of first support grooves 231 is each is formed in a circle, and the plurality of second support grooves 232 is each formed in a quadrangle. However, each of the plurality of first support grooves 231 and each of the plurality of second support grooves 232 may each be variously formed in a circle or polygons, such as a triangle or a quadrangle.

The plurality of second support grooves 232 may make some of the plurality of refrigerant condensing grooves 250 communicate with each other. The depth of the plurality of second support grooves 232 may be the same as the highest depth of the plurality of refrigerant condensing grooves 250.

When the refrigerant within the refrigerant chamber 220 is evaporated by being subjected to a heat exchange with the first cover part 110, pressure within the refrigerant chamber 220 rises. The cover plate 100 can be prevented from being laterally expanded by the risen pressure within the refrigerant chamber 220 because the plurality of support protrusions 131 and 132 is inserted into the plurality of support grooves 231 and 232.

A plurality of mounting grooves 141 and 142 may be formed in one surface of the cover plate 100. That is, the plurality of mounting grooves 141 and 142 may be formed in a surface that belongs to the cover plate 100 and on which the printed circuit board is mounted. The printed circuit board may be mounted on the plurality of mounting grooves 141 and 142. That is, the printed circuit board may be mounted on one surface of the cover plate 100 through a fastening member, such as a screw, which is fastened to the plurality of mounting grooves 141 and 142.

The plurality of mounting grooves 141 and 142 may extend into the plurality of support protrusions 131 and 132, respectively. Accordingly, the printed circuit board can be firmly mounted on the cover plate 100 because the depths of the plurality of mounting grooves 141 and 142 can be deeply formed.

The plurality of mounting grooves 141 and 142 may include a plurality of first mounting grooves 141 formed in one surface of the first cover part 110 and a plurality of second mounting grooves 142 formed in one surface of the second cover part 120.

The plurality of first mounting grooves 141 may extend into the plurality of first support protrusions 131, respectively. The plurality of second mounting grooves 142 may extend into the plurality of second support protrusions 132, respectively.

The plurality of first mounting grooves 141 may be formed at locations corresponding to the plurality of first support protrusions 131. The plurality of second mounting grooves 142 may be formed at locations corresponding to the plurality of second support protrusions 132. That is, the plurality of first mounting grooves 141 may be disposed in two columns in the width direction of the first cover part 110. The plurality of second mounting grooves 142 may be disposed in three columns in the width direction of the second cover part 120.

The plurality of first mounting grooves 141 and the plurality of second mounting grooves 142 may be formed in the same shape. However, the plurality of first mounting grooves 141 and the plurality of second mounting grooves 142 may be formed in different shapes. In the present embodiment, each of the plurality of first mounting grooves 141 and each of the plurality of second mounting grooves 142 are each formed in a circle, that is, the same shape, but may each be formed in a polygon, such as a triangle or a quadrangle.

A plurality of welding grooves 281 and 282 may be formed at parts that belong to the other surface of the heat sink body part 200 and that correspond to the plurality of support protrusions 131 and 132. That is, the plurality of welding grooves 281 and 282 may be formed at parts that belong to the outer surface of the heat sink body part 200 and that correspond to the plurality of support protrusions 131 and 132.

The plurality of welding grooves 281 and 282 may each be for laser-welding each of the plurality of support protrusions 131 and 132 onto the heat sink body part 200. That is, after the ends of the plurality of support protrusions 131 and 132 are brought into contact with the bottom surface of the refrigerant chamber 220, the ends of the plurality of support protrusions 131 and 132 may be laser-welded onto the bottom surface of the refrigerant chamber 220 by radiating a laser to each of the plurality of welding grooves 281 and 282.

If the plurality of support grooves 231 and 232 is formed in a surface that belongs to the refrigerant chamber 220 and that faces the other surface of the cover plate 100, the plurality of welding grooves 281 and 282 may be formed at parts corresponding to the plurality of support grooves 231 and 232.

The plurality of welding grooves 281 and 282 may include a plurality of first welding grooves 281 formed at parts that belong to the outer surface of the heat sink body part 200 and that correspond to the plurality of first support protrusions 131, and a plurality of second welding grooves 282 formed at parts that belong to the outer surface of the heat sink body part 200 and that correspond to the plurality of second support protrusions 132.

If the plurality of support grooves 231 and 232 is formed in the surface that belongs to the refrigerant chamber 220 and that faces the other surface of the cover plate 100, the plurality of first welding grooves 281 may be formed at parts that belong to the outer surface of the heat sink body part 200 and that correspond to the plurality of first support grooves 231. The plurality of second welding grooves 282 may be formed at parts that belong to the outer surface of the heat sink body part 200 and that correspond to the plurality of second support grooves 232.

The plurality of first welding grooves 281 may be for laser-welding the plurality of first support protrusions 131 onto the heat sink body part 200. The plurality of second welding grooves 282 may be for laser-welding the plurality of second support protrusions 132 onto the heat sink body part 200.

That is, after the ends of the plurality of first support protrusions 131 are brought into contact with the first opposite surface 221 of the refrigerant chamber 220, the ends of the plurality of first support protrusions 131 may be laser-welded onto the first opposite surface 221 by radiating a laser to each of the plurality of first welding grooves 281. Furthermore, after the ends of the plurality of second support protrusions 132 are brought into contact with the second opposite surface 222 of the refrigerant chamber 220, the ends of the plurality of second support protrusions 132 may be laser-welded onto the second opposite surface 222 of the refrigerant chamber 220 by radiating a laser to each of the plurality of second welding grooves 282.

Furthermore, if the plurality of support grooves 231 and 232 is formed in the surface that belongs to the refrigerant chamber 220 and that faces the other surface of the cover plate 100, after the ends of the plurality of first support protrusions 131 are brought into contact with the plurality of first support grooves 231, respectively, the ends of the plurality of first support protrusions 131 may be laser-welded onto the plurality of first support grooves 231 by radiating a laser to each of the plurality of first welding grooves 281. Furthermore, after the ends of the plurality of second support protrusions 132 are brought into contact with the plurality of second support grooves 232, respectively, the ends of the plurality of second support protrusions 132 may be laser-welded onto the plurality of second support grooves 232, respectively, by radiating a laser to each of the plurality of second welding grooves 282.

The plurality of first welding grooves 281 and the plurality of second welding grooves 282 may be formed in the same shape. However, the plurality of first welding grooves 281 and the plurality of second welding grooves 282 may be formed in different shapes. In the present embodiment, each of the plurality of first welding grooves 281 and each of the plurality of second welding grooves 282 are each formed in a circle, that is, the same shape, but may each be formed in a polygon, such as a triangle or a quadrangle.

A plurality of welding point protrusions 271 and 272 may further be formed in the other surface of the heat sink body part 200. That is, the plurality of welding point protrusions 271 and 272 may further be formed in the outer surface of the heat sink body part 200. The plurality of welding grooves 281 and 282 may be formed in the plurality of welding point protrusions 271 and 272, respectively.

The plurality of welding point protrusions 271 and 272 enables a worker to easily check a laser welding location, and can prevent the heat sink body part 200 from being deformed by heat that is generated upon laser welding by reinforcing the thickness of the heat sink body part 200.

The plurality of welding point protrusions 271 and 272 may include a plurality of first welding point protrusions 271 in which the plurality of first welding grooves 281 is formed, respectively, and a plurality of second welding point protrusions 272 in which the plurality of second welding grooves 282 is formed, respectively.

The plurality of first welding point protrusions 271 and the plurality of second welding point protrusions 272 may be formed in the same shape. However, the plurality of first welding point protrusions 271 and the plurality of second welding point protrusions 272 may be formed in different shapes.

A plurality of welding coupling parts 260 to which a plurality of heat dissipation fins (not illustrated) is coupled, respectively, by laser welding may be formed in the other surface of the heat sink body part 200 in a way to protrude therefrom. That is, the plurality of welding coupling parts 260 to which the plurality of heat dissipation fins is coupled, respectively, by laser welding may be formed in the outer surface of the heat sink body part 200 in a way to protrude therefrom. In this case, a contact area with external air can be secured because the heat dissipation fin is formed in a thin plate shape, and the heat dissipation fin may be for easily discharging the heat of the heat dissipation element.

The plurality of welding coupling parts 260 may be formed lengthwise in the width direction of the refrigerant chamber 220. The ends of the plurality of heat dissipation fins may be coupled to the plurality of welding coupling parts 260, respectively, by laser welding. The plurality of welding point protrusions 271 and 272 may extend from one side of the plurality of welding coupling parts 260.

Specifically, each of the plurality of welding coupling parts 260 may include a first heat dissipation fin support part 261 and a second heat dissipation fin support part 262. The first heat dissipation fin support part 261 and the second heat dissipation fin support part 262 may be formed lengthwise in the width direction of the refrigerant chamber 220. The first heat dissipation fin support part 261 and the second heat dissipation fin support part 262 may be spaced apart from each other in the length direction of the refrigerant chamber 220. The second heat dissipation fin support part 262 may be spaced apart from the first heat dissipation fin support part 261 in the length direction of the refrigerant chamber 220, and may be formed to face the first heat dissipation fin support part 261. The ends of the plurality of heat dissipation fins may each be inserted into a space in which each of the first heat dissipation fin support part 261 and each of the second heat dissipation fin support part 262 are spaced apart from each other, and may be laser-welded onto at least one of the first heat dissipation fin support part 261 and the second heat dissipation fin support part 262.

The plurality of welding point protrusions 271 and 272 may extend from one side of the first heat dissipation fin support part 261. However, the plurality of welding point protrusions 271 and 272 may extend from one side of any one of the first heat dissipation fin support part 261 and the second heat dissipation fin support part 262.

As described above, in the heat sink structure according to an embodiment of the present disclosure, the heat sink body part 200 is covered with the cover plate 100 on which the printed circuit board is mounted, the refrigerant chamber 220 filled with the refrigerant is formed in the heat sink body part, and the plurality of refrigerant condensing grooves 250 in which a gaseous refrigerant subjected to a heat exchange with heat generated from the heat dissipation element mounted on the printed circuit board is condensed while flowing is formed in the bottom surface of the refrigerant chamber 220. Accordingly, the heat generated from the heat dissipation element can be rapidly discharged by rapidly condensing the gaseous refrigerant subjected to a heat exchange with the heat generated from the heat dissipation element, a size can be minimized, and heat dissipation performance can also be improved.

A person having ordinary knowledge in the art to which the present disclosure pertains will understand that the present disclosure may be implemented in other detailed forms without changing the technical spirit or essential characteristics of the present disclosure. Accordingly, the aforementioned embodiments should be construed as being only illustrative, but should not be construed as being restrictive from all aspects. The scope of the present disclosure is defined by the appended claims rather than by the detailed description, and all changes or modifications derived from the meanings and scope of the claims and equivalent concepts thereof should be interpreted as being included in the scope of the present disclosure.

.

### [Industrial Applicability]

The present disclosure provides the heat sink structure which can rapidly discharge heat generated from the heat dissipation element by rapidly condensing a gaseous refrigerant subjected to a heat exchange with the heat generated from the heat dissipation element, can minimize a size, and can also improve heat dissipation performance

## Claims

1. A heat sink structure comprising:
a cover plate configured to have a printed circuit board comprising a heat dissipation element mounted on one surface thereof and to receive heat of the heat dissipation element; and
a heat sink body part configured to have an internal space partitioned into an accommodation space in which the printed circuit board is accommodated and a refrigerant chamber filled with the refrigerant by the cover plate,
wherein a plurality of refrigerant condensing grooves in which a gaseous refrigerant subjected to a heat exchange with the cover plate is condensed while flowing is formed in at least one surface of the refrigerant chamber.

2. The heat sink structure of claim 1, wherein the plurality of refrigerant condensing grooves is formed on a surface that belongs to the refrigerant chamber and that faces other surface of the cover plate.

3. The heat sink structure of claim 2, wherein the cover plate comprises:
a first cover part that is a part corresponding to the heat dissipation element, and
a second cover part formed to extend from one side of the first cover part,
wherein the plurality of refrigerant condensing grooves is formed at parts corresponding to the second cover part.

4. The heat sink structure of claim 3, wherein a plurality of heat exchange grooves subjected to a heat exchange with the refrigerant is formed in a surface that belongs to the first cover part and that faces the refrigerant chamber.

5. The heat sink structure of claim 1, wherein:
a width of the refrigerant chamber is formed to be smaller than a width of the accommodation space, and
the cover plate covers one opened surface that belongs to the refrigerant chamber and that communicates with the accommodation space.

6. The heat sink structure of claim 3, wherein a surface that belongs to the refrigerant chamber and that faces the other surface of the cover plate comprises:
a first opposite surface that faces the first cover part, and
a second opposite surface that faces the second cover part and in which a plurality of refrigerant condensing grooves is formed,
wherein a side of each of the plurality of refrigerant condensing grooves, which is directed toward the first opposite surface, is formed of a slant part.

7. The heat sink structure of claim 6, wherein the slant part is formed of a plurality of first step parts.

8. The heat sink structure of claim 1, wherein:
a second step part is formed at an edge of the refrigerant chamber, and
an edge of the cover plate is seated in the second step part, and other surface of the cover plate is disposed by being spaced apart from a surface that belongs to the refrigerant chamber and that faces the other surface of the cover plate.

9. The heat sink structure of claim 8, wherein a third step part seated in the second step part is formed at the edge of the cover plate.

10. The heat sink structure of claim 1, wherein a plurality of support protrusions that separates the other surface of the cover plate from a surface that belongs to the refrigerant chamber and that faces the other surface of the cover plate and supports the other surface of the cover plate is formed in the other surface of the cover plate.

11. The heat sink structure of claim 10, wherein a plurality of support grooves into which the plurality of support protrusions is inserted, respectively, is formed in the surface that belongs to the refrigerant chamber and that faces the other surface of the cover plate.

12. The heat sink structure of claim 10, wherein:
a plurality of mounting grooves on which the printed circuit board is mounted is formed on one surface of the cover plate, and
the plurality of mounting grooves extends into the plurality of support protrusions, respectively.

13. The heat sink structure of claim 10, wherein a plurality of welding grooves for laser-welding each of the plurality of support protrusions onto the heat sink body part is formed at parts that belong to an outer surface of the heat sink body part and that correspond to the plurality of support protrusions portions.

14. The heat sink structure of claim 13, wherein:
a plurality of welding point protrusions is further formed in the outer surface of the heat sink body part, and
the plurality of welding grooves is formed in the plurality of welding point protrusions, respectively.

15. The heat sink structure of claim 14, wherein:
a plurality of welding coupling parts to which ends of a plurality of heat dissipation fins are coupled, respectively, by laser welding is formed in the outer surface of the heat sink body part in a way to protrude therefrom,
the plurality of welding coupling parts is formed lengthwise in a width direction of the refrigerant chamber, and
the plurality of welding point protrusions extends from one side of the plurality of welding coupling parts.
